# EUROPEAN PATENT APPLICATION

(11) **EP 4 768 967 A1**
(43) Date of publication of application: **01.07.2026**
(21) Application number: 24882651.3
(22) Date of filing: 13.09.2024
(51) Int. Cl.: G01R 31/396, G01R 31/385, G01R 31/371, G01R 27/02, G08C 17/02, H01M 10/48, H02J 7/00, H01M 10/42

(54) **BATTERY DIAGNOSIS APPARATUS AND OPERATION METHOD THEREOF**

(30) Priority: 26.10.2023 KR 20230144565
(71) Applicant: LG Energy Solution, Ltd., Seoul 07335 (KR)
(72) Inventor: LEE, Seung Hyun, Daejeon 34122 (KR); SEO, Bo Hyun, Daejeon 34122 (KR); KIM, Tae Youn, Daejeon 34122 (KR)
(74) Representative: Plasseraud IP
(86) International application number: PCT/KR2024/013996
(87) International publication number: WO 2025/089622

(57) **Abstract**

A battery diagnosis apparatus according to an embodiment disclosed herein includes a slave battery management system (BMS) configured to generate unit state information by measuring a state of a battery unit, a management unit configured to generate pack state information by measuring a state of a battery pack and control an operation of a relay related to power supply of the battery pack based on at least one of the unit state information and the pack state information, and a master BMS configured to receive the unit state information and the pack state information from the management unit and monitor battery cells included in at least one of the battery unit and the battery pack based on at least one of the unit state information and the pack state information.

## Description

### TECHNICAL FIELD

### CROSS-REFERENCE TO RELATED APPLICATION

This application claims priority to and the benefit of Korean Patent Application No. 10-2023-0144565 filed in the Korean Intellectual Property Office on October 26, 2023, the entire content of which is incorporated herein by reference.

### TECHNICAL FIELD

Embodiments disclosed herein relate to a battery diagnosis apparatus and an operating method thereof.

### BACKGROUND ART

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

As industrial fields using batteries expand, battery management systems (BMSs) diagnosing safety of batteries are also developing. The BMS may diagnose performance of a battery by using various diagnosis algorithms, and perform appropriate control according to a state of the battery.

BMSs may include a master BMS and a slave BMS. The slave BMS may manage a battery module, included in a battery pack, based on state information regarding the battery module. The master BMS may receive the state information regarding the battery module from the slave BMS, measure voltage, current, and resistance values in the unit of a battery pack, and monitor states of the battery module included in the battery pack and battery cells.

### DISCLOSURE

### TECHNICAL PROBLEM

When a master BMS performs data exchange with a slave BMS through wired or wireless communication and receives information about an abnormal battery from the slave BMS, the master BMS may prevent an accident, such as explosion, etc., occurring due to the abnormal battery by controlling an operation of a relay connecting a battery pack to a load.

However, even when communication between the master BMS and the slave BMS is performed normally, the master BMS may perform relay control after collecting a plurality of pieces of data from a plurality of slave BMSs, resulting in a delay corresponding to an abnormal signal.

Moreover, when the master BMS fails to receive the abnormal signal or the master BMS is in an inactive state (e.g., an electric vehicle is turned off) due to abnormality in communication between the master BMS and the slave BMS, then the master BMS may not be able to perform relay control and thus abnormality may occur not only in a battery pack, but also in a load connected to the battery pack, due to the abnormal battery.

Technical problems of the embodiments disclosed herein are not limited to the above-described technical problems, and other unmentioned technical problems would be clearly understood by one of ordinary skill in the art from the following description.

### TECHNICAL SOLUTION

A battery diagnosis apparatus according to an embodiment disclosed herein includes a slave battery management system (BMS) configured to generate unit state information by measuring a state of a battery unit, a management unit configured to generate pack state information by measuring a state of a battery pack and control an operation of a relay related to power supply of the battery pack based on at least one of the unit state information and the pack state information, and a master BMS configured to receive the unit state information and the pack state information from the management unit and monitor battery cells included in at least one of the battery unit and the battery pack based on at least one of the unit state information and the pack state information.

In an embodiment, the controller may be further configured to open the relay when an abnormal signal is included in at least one of the unit state information and the pack state information.

In an embodiment, the management unit may include a communication interface configured to communicate with the master BMS or the slave BMS.

In an embodiment, the communication interface and the slave BMS may be further configured to operate with power supplied from a constant power source.

In an embodiment, the communication interface may be further configured to activate the controller when an abnormal signal is included in the unit state information, and the controller may be further configured to open the relay.

In an embodiment, the battery unit may include a battery module or a battery cell included in the battery pack.

In an embodiment, the unit state information may include at least one of voltage, current, and temperature values of each of battery cells included in the battery unit.

In an embodiment, the pack state information may include at least one of voltage, current, and insulating resistance values of the battery pack.

An operating method of a battery diagnosis apparatus according to an embodiment disclosed herein includes generating unit state information by measuring a state of a battery unit, generating pack state information by measuring a state of a battery pack, and controlling an operation of a relay related to power supply of the battery pack based on at least one of the unit state information and the pack state information.

In an embodiment, the controlling may include opening the relay when an abnormal signal is included in at least one of the unit state information and the pack state information.

In an embodiment, the operating method may further include activating at least one of the generating of the pack state information and the controlling when an abnormal signal is included in the unit state information.

In an embodiment, the battery unit may include a battery module or a battery cell included in the battery pack.

In an embodiment, the unit state information may include at least one of voltage, current, and temperature values of each of battery cells included in the battery unit.

In an embodiment, the pack state information may include at least one of voltage, current, and insulating resistance values of the battery pack.

### ADVANTAGEOUS EFFECTS

The battery diagnosis apparatus and the operating method thereof according to various embodiments disclosed herein may perform relay operation control performed by the master BMS by using a separate component, thereby shortening a time caused by a process of collecting information from a plurality of slave BMSs.

Moreover, the battery diagnosis apparatus and the operating method thereof according to embodiments disclosed herein may connect a communication interface to at least one slave BMS, thereby allowing the communication interface to receive an abnormal signal even when the master BMS is in the inactive state (e.g., the electric vehicle is turned off) or communication between the master BMS and the slave BMS is not smooth.

The technical effects of the battery diagnosis apparatus and the operating method thereof according to embodiments disclosed in the present document are not limited to the effects mentioned above, and other effects not mentioned will be clearly understood by those of ordinary skill in the art according to the disclosure of the present document.

### DESCRIPTION OF DRAWINGS

FIG. 1 illustrates a system for a battery pack to supply power to a load, according to an embodiment disclosed herein.
FIG. 2 is a block diagram of a battery diagnosis apparatus according to an embodiment disclosed herein.
FIGS. 3 and 4 are block diagrams of a management unit according to various embodiments disclosed herein.
FIG. 5 is a flowchart showing a method, performed by a battery diagnosis apparatus, of controlling an operation of a relay, according to an embodiment disclosed herein.
FIG. 6 is a flowchart showing a method, performed by a battery diagnosis apparatus, of activating a function to control an operation of a relay, according to an embodiment disclosed herein.
FIG. 7 is a block diagram showing a hardware configuration of a computing system for implementing an operating method of a battery diagnosis apparatus, according to an embodiment disclosed herein.

With regard to the description of the drawings, identical reference numerals may be used to refer to identical or related elements.

### MODE FOR INVENTION

Hereinafter, embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st", "2nd," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly or wirelessly), or indirectly (e.g., via a third element).

A method according to various embodiments disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. In the case of online distribution, at least a part of a computer program product may be at least temporarily stored in a machine-readable storage medium such as a memory of a server of a manufacturer, a server of an application store, or a relay server, or may be generated temporarily.

According to embodiments disclosed herein, each of the above-described components (e.g., a module or program) may include a single entity or a plurality of entities, some of which may be separately disposed on other components. According to embodiments disclosed herein, one or more of the above-described components or operations may be omitted, or one or more other components or operations may be added. Alternatively or additionally, a plurality of components (e.g., modules or programs) may be integrated into one component. In this case, the integrated component may perform one or more functions of each of the plurality of components in a manner that is the same as or similar to a corresponding component of the plurality of components before the integration. According to embodiments disclosed herein, operations performed by a module, a program, or other components may be executed sequentially, in parallel, repeatedly, or heuristically, or one or more of the operations may be executed in a different order or omitted, or one or more other operations may be added.

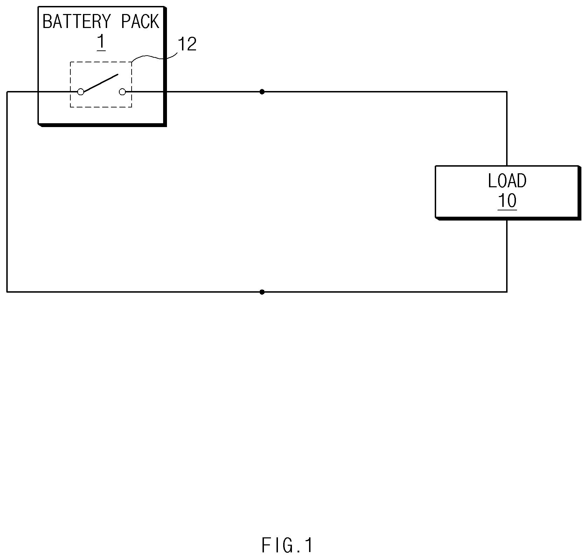

FIG. 1 illustrates a system for a battery pack to supply power to a load, according to an embodiment disclosed herein.

Referring to FIG. 1, a battery pack 1 may supply power to a load 10. The battery pack 1 may supply power to the load 10 when a relay 12 is in a short-circuited state. Herein, the load 10 may be a load included in a mobile device (e.g., a mobile phone, a laptop computer, a smart phone, a smart pad), an electric vehicle (e.g., an electric vehicle (EV), a hybrid EV (HEV), a plug-in HEV (PHEV), a fuel cell EV (FCEV)), or other electronic devices. Hereinbelow, a description will be made assuming that the load 10 refers to a load included in an electric vehicle.

The battery pack 1 may control an operation of the relay 12. For example, the battery pack 1 may block power supply to the load 10 by opening the relay 12 when an abnormal battery cell is sensed. In this way, abnormality may be prevented from occurring in the load 10.

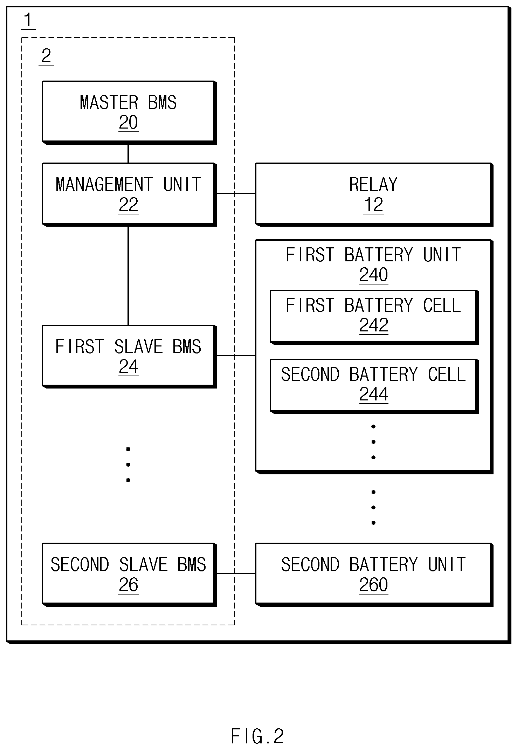

Hereinbelow, with reference to FIGS. 2 to 7, a method, performed by the battery diagnosis apparatus included in the battery pack 1, of controlling an operation of the relay 12 connecting the battery pack 1 to the load 10 will be described.

FIG. 2 is a block diagram of a battery diagnosis apparatus according to an embodiment disclosed herein.

Referring to FIG. 2, a battery diagnosis apparatus 2 may include a master BMS 20, a management unit 22, and slave BMSs 24 and 26. In an embodiment, the battery diagnosis apparatus 2 may be included in a battery management system (BMS) capable of diagnosing the battery pack 1, and operations performed in the battery diagnosis apparatus 2 may be performed in the BMS. The operation of the battery diagnosis apparatus 2 may also be performed in various devices such as not only a BMS included in the battery pack 1, but also a server, a cloud, a charger, a charger/discharger, etc.

The master BMS 20 may monitor states of battery cells included in the battery pack 1. The master BMS 20 may obtain state information generated by each of the management unit 22 and the slave BMSs 24 and 26 and monitor a state of the battery pack 1 or each battery cell included in the battery pack 1. Herein, the state information may include at least one of voltage, current, resistance, state of charge (SOC), state of health (SOH), and temperature of the battery pack 1 or each battery cell.

Each of the slave BMSs 24 and 26 may measure a state of each of battery units 240 and 260. Herein, each of the battery units 240 and 260 may indicate a group including one or more battery cells. For example, each of the battery units 240 and 260 may be a battery module included in the battery pack 1 or a battery cell. While it is illustrated in FIG. 2 that there are two battery units, the number of battery units may be n (n is a natural number), without being limited to the illustration.

The first battery unit 240 may include a plurality of battery cells 242 and 244. While the battery cells 242 and 244 included in the first battery unit 240 are shown in FIG. 2, the second battery unit 260 may also include a plurality of battery cells. Moreover, it is illustrated in FIG. 2 that the plurality of battery cells 242 and 244 included in the first battery unit 240 are two battery cells, the first battery cell may include m battery cells (m is a natural number of at least 2), without being limited to the illustration. According to an embodiment, the plurality of battery cells 242 and 244 may include, but not limited to, a lithium-ion (Li-ion) battery, an Li-ion polymer battery, a nickel-cadmium (Ni-Cd) battery, a nickel metal hydride (Ni-MH) battery, a lithium iron phosphate (LFP) battery, a nickel cobalt manganese oxide (NCM) battery, etc.

Each of the slave BMSs 24 and 26 may generate unit state information. Herein, the unit state information may include at least one of voltage, current, and temperature values of each battery cell included in a battery unit. For example, the first slave BMS 24 may measure a state of each of the plurality of battery cells 242 and 244 included in the first battery unit 240 to generate first unit state information including at least one of voltage, current, and temperature values of each of the battery cells 242 and 244.

The slave BMSs 24 and 26 may be connected in a daisy chain manner. Herein, the daisy chain manner may indicate a manner in which a plurality of devices are continuously connected in a bus connection manner. For example, the first slave BMS 24 may be connected to the second slave BMS 26 that may be connected to a third slave BMS (not shown). The third unit state information generated in the third slave BMS (not shown) may be transmitted to the first slave BMS 24 through the second slave BMS 26, and the first slave BMS 24 may transmit the third unit state information to the management unit 22.

The management unit 22 may receive the unit state information generated in each of the slave BMSs 24 and 26 through the first slave BMS 24. For example, the management unit 22 may receive the first unit state information regarding the first battery unit 240 from the first slave BMS 24. The management unit 22 may receive the second unit state information regarding the second battery unit 260 from the second slave BMS 26 through the first slave BMS 24.

The management unit 22 may measure the state of the battery pack 1 to generate pack state information. Herein, the pack state information may include, but not limited to, at least one of voltage, current, and insulating resistance values of the battery pack 1.

The management unit 22 may control an operation of the relay 12 related to power supply of the battery pack 1 based on at least one of unit state information and pack state information. The management unit 22 may control an operation of the relay 12 related to power supply of the battery pack 1 when the at least one of the unit state information and the pack state information includes an abnormal signal. For example, the management unit 22 may open the relay 12 when the management unit 22 receives first unit state information including an abnormal signal regarding the first battery cell 242.

The management unit 22 may open the relay 12 to block power supply to the load 10. The management unit 22 may prevent abnormality from occurring in the load 10 by blocking power supply to the load 10. As the management unit 22 controls the operation of the relay 12 based on at least one of the unit state information and the pack state information, a time required for the master BMS 20 to collect all information and control the operation of the relay 12 may be reduced.

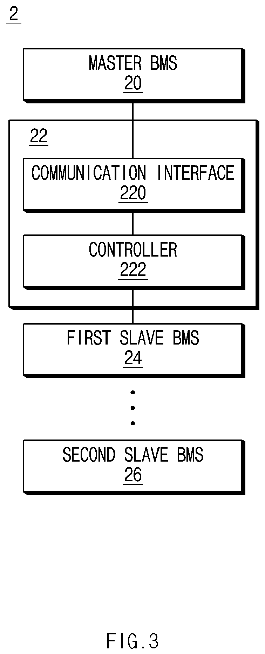

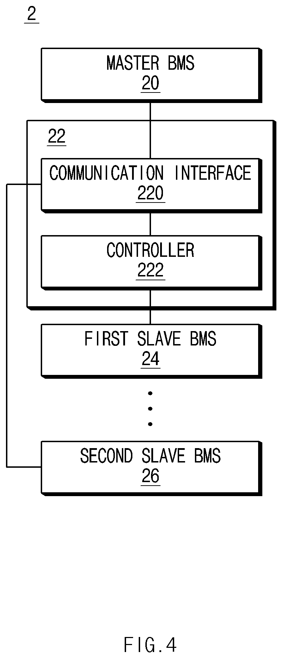

FIGS. 3 and 4 are block diagrams of a management unit according to various embodiments disclosed herein.

Referring to FIG. 3, the management unit 22 may include a communication interface 220 and a controller 222.

The communication interface 220 may communicate with the master BMS 20 or the slave BMSs 24 and 26. The communication interface 220 may enable data exchange between the master BMS 20 and the slave BMSs 24 and 26.

The controller 222 may measure the state of the battery pack 1 to generate the pack state information.

The controller 222 may receive unit state information generated in each of the slaves BMSs 24 and 26. The controller 222 may obtain the unit state information generated in each of the slave BMSs 24 and 26 through the first slave BMS 24. For example, the controller 222 may obtain the first unit state information generated by the first slave BMS 24 from the first slave BMS 24. The controller 222 may obtain the second unit state information generated by the second slave BMS 26 through the first slave BMS 24 connected to the second slave BMS 26 in the daisy chain manner.

The controller 222 may control an operation of the relay 12 related to power supply of the battery pack 1 based on at least one of unit state information and pack state information. The controller 222 may open the relay 12 when an abnormal signal is included in at least one of the unit state information and the pack state information.

Referring to FIG. 4, the communication interface 220 may be connected to the second slave BMS 26 wiredly or wirelessly.

The communication interface 220 may obtain the unit state information through the second slave BMS 26. Herein, the unit state information may include the first unit state information generated by the first slave BMS 24 and the second unit state information generated by the second slave BMS 26. For example, the communication interface 220 may obtain the second unit state information generated by the second slave BMS 26 from the second slave BMS 26. The communication interface 220 may receive the first unit state information generated by the first slave BMS 24 through the second slave BMS 26 connected to the first slave BMS 24 in the daisy chain manner.

In an embodiment, the communication interface 220 and the slave BMSs 24 and 26 may receive power through a constant power source. The communication interface 220 and the slave BMSs 24 and 26 may be in a constant active state by receiving power through the constant power source. Herein, the constant power source, which is an external power source of the battery pack 1, may be a 12 V battery included in an electric vehicle. For example, the first slave BMS 24 and the second slave BMS 26 may measure states of the first battery unit 240 and the second battery unit 260 through power supplied from the constant power source. The communication interface 220 may receive the unit state information through the second slave BMS 26. Herein, a reason why constant power is supplied to the communication interface 220 and the slave BMSs 24 and 26 is intended to use minimal power in control of the operation of the relay 12 by detecting an abnormal battery cell.

As the communication interface 220 is wiredly or wirelessly connected to the second slave BMS 26, the communication interface 220 may receive unit state information including an abnormal signal through the second slave BMS 26 even when the controller 222 is in the inactive state (e.g., the electric vehicle is turned off).

The communication interface 220 may activate the controller 222 when the unit state information obtained through the second slave BMS 26 includes an abnormal signal. The communication interface 220 may activate the controller 222 to control an operation of the relay 12 when the communication interface 220 receives the unit state information including an abnormal signal through the second slave BMS 26.

In an embodiment, the communication interface 220 may generate a wake-up signal when the unit state information includes an abnormal signal. The communication interface 220 may activate the controller 222 based on the wake-up signal. The controller 222 may be activated based on the wake-up signal to control the operation of the relay 12. Herein, the wake-up signal may indicate a signal for activating the controller 222.

As a result, by supplying power to the slave BMSs 24 and 26 through the constant power source, the states of the battery units 240 and 260 may be measured every designated period to detect an abnormal signal, and by supplying power to the communication interface 220 through the constant power source, the controller 222 in the inactive state may be activated, thereby allowing the controller 222 to perform diagnosis on the battery pack 1 and operation control of the relay 12.

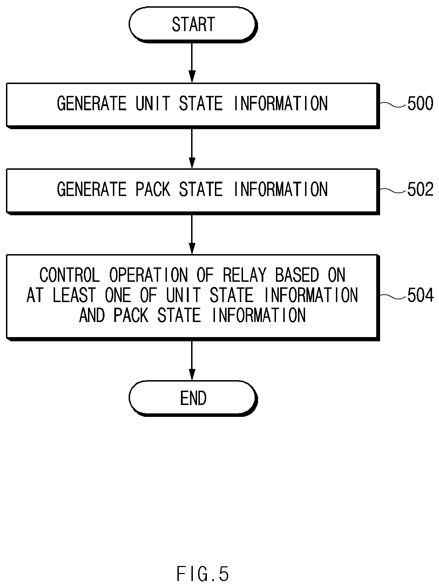

FIG. 5 is a flowchart showing a method, performed by a battery diagnosis apparatus, of controlling an operation of a relay, according to an embodiment disclosed herein.

Referring to FIG. 5, in operation 500, the battery diagnosis apparatus 2 may generate unit state information.

In operation 502, the battery diagnosis apparatus 2 may generate pack state information.

In operation 504, the battery diagnosis apparatus 2 may control an operation of a relay based on at least one of the unit state information and the pack state information. The battery diagnosis apparatus 2 may open the relay 12 when an abnormal signal is included in at least one of the unit state information and the pack state information.

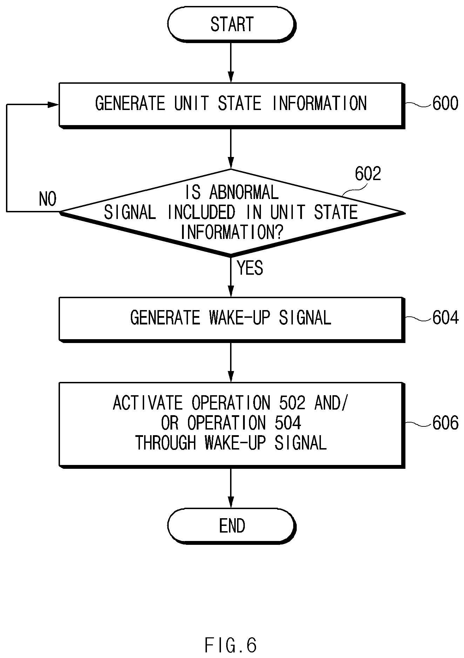

FIG. 6 is a flowchart showing a method of activating some operating schemes of a battery diagnosis apparatus, according to an embodiment disclosed herein.

Hereinbelow, assuming that some components (e.g., the master BMS 20 and the controller 222) of the battery diagnosis apparatus 2 are in the inactive state, a method of activating operations performed by the some components (e.g., the master BMS 20 and the controller 222) will be described.

In operation 600, the battery diagnosis apparatus 2 may generate unit state information. For example, the slave BMSs 24 and 26 of the battery diagnosis apparatus 2 may receive power through a constant power source to measure states of the battery units 240 and 260 every periods, thereby generating the unit state information.

In operation 602, the battery diagnosis apparatus 2 may identify whether an abnormal signal is included in the unit state information. For example, the communication interface 220 of the battery diagnosis apparatus 2 may receive power through the constant power source to determine whether the abnormal signal is included in the unit state information. In an embodiment, the communication interface 220 may be connected to the second slave BMS 26 to obtain the unit state information generated by each of the slave BMSs 24 and 26 through the second slave BMS 26.

The battery diagnosis apparatus 2 may return to operation 600 and generate the unit state information every periods to continuously monitor whether the abnormal battery cell is detected, when the abnormal signal is not included in the unit state information.

In operation 604, the battery diagnosis apparatus 2 may generate the wake-up signal when the abnormal signal is included in the unit state information. For example, when the abnormal signal is included in the unit state information, the communication interface 220 of the battery diagnosis apparatus 2 may generate the wake-up signal.

In operation 606, the battery diagnosis apparatus 2 may activate an operation of generating the pack state information based on the wake-up signal (operation 502 of FIG. 5) and/or an operation of controlling an operation of the relay 12 (operation 504 of FIG. 5). For example, the communication interface 220 of the battery diagnosis apparatus 2 may activate the controller 222 based on the wake-up signal and the activated controller 222 may measure the state of the battery pack 1 and generate the pack state information thereon.

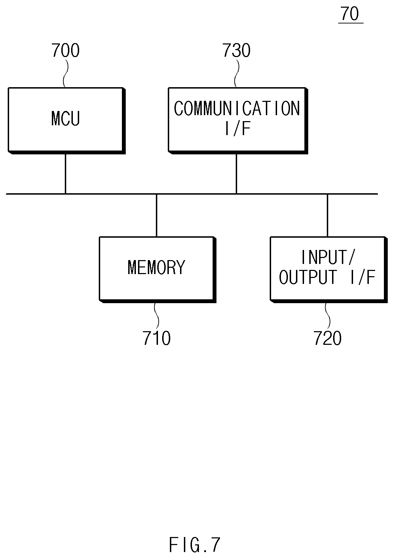

FIG. 7 is a block diagram showing a hardware configuration of a computing system for implementing an operating method of a battery diagnosis apparatus, according to an embodiment disclosed herein.

Referring to FIG. 7, a computing system 70 according to an embodiment disclosed herein may include a micro control unit (MCU) 700, a memory 710, an input/output I/F 720, and a communication I/F 730.

The MCU 700 may be a processor that executes various programs (e.g., a battery voltage analysis program, etc.) stored in the memory 710, processes various data through these programs, and perform the above-described functions of the battery management apparatus 2 shown in FIGS. 2 to 4.

The memory 710 may store various programs regarding operations of the battery management apparatus 2. Moreover, the memory 710 may store operation data of the battery management apparatus 2.

The memory 710 may be provided in plural, depending on a need. The memory 710 may be a volatile or nonvolatile memory. For the memory 710 as the volatile memory, random access memory (RAM), dynamic RAM (DRAM), static RAM (SRAM), etc., may be used. For the memory 710 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 710 are merely examples and are not limited thereto.

The input/output I/F 720 may provide an interface for transmitting and receiving data by connecting an input device (not shown) such as a keyboard, a mouse, a touch panel, etc., and an output device such as a display (not shown), etc., with the MCU 700.

The communication I/F 730, which is a component capable of transmitting and receiving various data to and from a server, may be various types of devices capable of supporting wired or wireless communication. For example, a program for resistance measurement and abnormality diagnosis or various data, etc., may be transmitted and received to and from a separately provided external server through the communication I/F 730.

Terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in this document.

The above description is merely illustrative of the technical idea disclosed herein, and various modifications and variations will be possible without departing from the essential characteristics of the embodiments disclosed herein by those of ordinary skill in the art to which the embodiments disclosed herein pertains. Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of this document.

## Claims

1. A battery diagnosis apparatus comprising:
a slave battery management system (BMS) configured to generate unit state information by measuring a state of a battery unit;
a management unit configured to generate pack state information by measuring a state of a battery pack and control an operation of a relay related to power supply of the battery pack based on at least one of the unit state information and the pack state information; and
a master BMS configured to receive the unit state information and the pack state information from the management unit and monitor battery cells included in at least one of the battery unit and the battery pack based on at least one of the unit state information and the pack state information.

2. The battery diagnosis apparatus of claim 1, wherein the controller is further configured to open the relay when an abnormal signal is included in at least one of the unit state information and the pack state information.

3. The battery diagnosis apparatus of claim 1, wherein the management unit comprises a communication interface configured to communicate with the master BMS or the slave BMS.

4. The battery diagnosis apparatus of claim 3, wherein the communication interface and the slave BMS are further configured to operate with power supplied from a constant power source.

5. The battery diagnosis apparatus of claim 4, wherein the communication interface is further configured to activate the controller when an abnormal signal is included in the unit state information, and
the controller is further configured to open the relay.

6. The battery diagnosis apparatus of claim 1, wherein the battery unit comprises a battery module or a battery cell included in the battery pack.

7. The battery diagnosis apparatus of claim 1, wherein the unit state information comprises at least one of voltage, current, and temperature values of each of battery cells included in the battery unit.

8. The battery diagnosis apparatus of claim 1, wherein the pack state information comprises at least one of voltage, current, and insulating resistance values of the battery pack.

9. An operating method of a battery diagnosis apparatus, the operating method comprising:
generating unit state information by measuring a state of a battery unit;
generating pack state information by measuring a state of a battery pack; and
controlling an operation of a relay related to power supply of the battery pack based on at least one of the unit state information and the pack state information.

10. The operating method of claim 9, wherein the controlling comprises opening the relay when an abnormal signal is included in at least one of the unit state information and the pack state information.

11. The operating method of claim 9, further comprising activating at least one of the generating of the pack state information and the controlling when an abnormal signal is included in the unit state information.

12. The operating method of claim 9, wherein the battery unit comprises a battery module or a battery cell included in the battery pack.

13. The operating method of claim 9, wherein the unit state information comprises at least one of voltage, current, and temperature values of each of battery cells included in the battery unit.

14. The operating method of claim 9, wherein the pack state information comprises at least one of voltage, current, and insulating resistance values of the battery pack.
